# DEMANDE DE BREVET EUROPEEN

(11) **EP 4 737 920 A1**
(43) Date de publication de la demande: **06.05.2026**
(21) Numéro de dépôt: 25210162.1
(22) Date de dépôt: 21.10.2025
(51) Int. Cl.: G01R 31/378

(54) **PROCEDE DE DETECTION D'UN TYPE DE PILE OU D'ACCUMULATEUR**

(30) Priorité: 30.10.2024 FR 2411858
(71) Demandeur: DELTA DORE, 35270 Bonnemain (FR)
(72) Inventeur: CHABANNES, André, 35270 BONNEMAIN (FR); LAMBERT, David, 35270 BONNEMAIN (FR)
(74) Mandataire: Cabinet Le Guen Maillet

(57) **Abrégé**

La présente invention concerne un procédé et un dispositif de détermination du type de pile ou d'accumulateur utilisé dans un dispositif. Selon l'invention :
- on mesure (E400, E404) la tension délivrée par la pile ou de l'accumulateur lorsque la pile ou l'accumulateur délivre un courant inférieur à une première valeur prédéterminée, et un courant supérieur à la première valeur prédéterminée,
- on calcule (E405) une résistance équivalente série de la pile ou de l'accumulateur à partir des deux mesures et du courant au moins supérieur à la seconde valeur prédéterminée,
- on détermine (E407, E408) que le type de pile ou d'accumulateur est du premier type en fonction des tensions et de la résistance équivalente série.

## Description

### DOMAINE TECHNIQUE

La présente invention concerne un procédé de détection d'un type de pile ou d'accumulateur dans un dispositif par exemple alimenté par la pile ou l'accumulateur.

### ETAT DE LA TECHNIQUE ANTERIEURE

Dans les dispositifs alimentés par pile, il est intéressant de fournir un indicateur du niveau de charge de la pile ou de l'accumulateur pour l'utilisateur du dispositif. Celui-ci peut ainsi remplacer la pile ou l'accumulateur avant que celle-ci ne soit plus capable de fournir l'énergie électrique nécessaire au fonctionnement du dispositif.

Actuellement le niveau de capacité restante de la pile ou de l'accumulateur d'un dispositif peut être estimé en mesurant la tension électrique fournie par la pile ou l'accumulateur lorsque celle-ci délivre un courant nul ou faible.

Malheureusement, la courbe de décharge d'une pile ou d'un accumulateur au cours de son utilisation varie selon la technologie de la pile ou de l'accumulateur, les piles de type alcaline ou les accumulateurs NiMH (Nickel Métal Hydrure) ou sources d'alimentation Lithium présentent des tensions différentes en fonction de leur niveau de décharge.

Ainsi, si le dispositif alimenté par pile ou accumulateur affiche une gauge du niveau de charge de la pile basée sur la tension dite à vide celle-ci sera erronée. La conséquence est que le dispositif signalerait un niveau de pile faible alors que des accumulateurs NiMH sont utilisés et ne sont que légèrement déchargés.

La présente invention vise à permettre à un utilisateur de choisir le type de pile ou d'accumulateur qu'il désire utiliser tout en garantissant que l'information représentative du niveau de charge de la pile soit correcte quel que soit le type de pile ou d'accumulateur choisi.

### EXPOSE DE L'INVENTION

Il est proposé un procédé de détermination du type de pile ou d'accumulateur utilisé dans un dispositif, caractérisé en ce que le procédé comporte les étapes de :
- mesure de la tension délivrée par la pile ou l'accumulateur lorsque la pile ou l'accumulateur délivre un courant inférieur à une première valeur prédéterminée,
- détermination que la pile ou l'accumulateur est d'un premier type si la tension délivrée est supérieure à un premier seuil prédéterminé,
- mesure de la tension délivrée par la pile ou l'accumulateur lorsque la pile ou l'accumulateur délivre un courant au moins supérieur à une seconde valeur prédéterminée,
- calcul d'une résistance équivalente de la pile ou de l'accumulateur à partir des deux mesures et du courant au moins supérieur à la seconde valeur prédéterminée,
- détermination que la pile ou l'accumulateur est d'un second type si la résistance équivalente série est inférieure à un second seuil prédéterminé,
- détermination que la pile ou l'accumulateur est du premier type si la résistance équivalente série est supérieure au second seuil prédéterminé.

L'invention concerne aussi un dispositif de détermination du type de pile ou d'accumulateur utilisé dans un dispositif, caractérisé en ce que le dispositif comporte :
- des moyens de mesure de la tension délivrée par la pile ou l'accumulateur lorsque la pile ou l'accumulateur délivre un courant inférieur à une première valeur prédéterminée,
- des moyens de détermination que la pile ou l'accumulateur est d'un premier type si la tension délivrée est supérieure à un premier seuil prédéterminé,
- des moyens de mesure de la tension délivrée par la pile ou l'accumulateur lorsque la pile ou l'accumulateur délivre un courant au moins supérieur à une seconde valeur prédéterminée,
- des moyens de calcul d'une résistance équivalente série de la pile ou de l'accumulateur à partir des deux mesures et du courant au moins supérieur à la seconde valeur prédéterminée,
- des moyens de détermination que la pile ou l'accumulateur est d'un second type si la résistance équivalente série est inférieure à un second seuil prédéterminé,
- des moyens de détermination que la pile ou l'accumulateur est du premier type si la résistance équivalente série est supérieure au second seuil prédéterminé.

Ainsi, la présente invention permet à partir de l'analyse de la tension à vide et de la résistance série de la pile ou de l'accumulateur de déterminer quel type de pile ou d'accumulateur est utilisé.

Selon un mode de réalisation particulier, le premier type est de type pile alcaline et le second type est de type accumulateur NiMH.

Ainsi, la présente invention permet à un utilisateur de choisir une pile ou un accumulateur r tout en garantissant que l'information représentative du niveau de charge de la pile soit correcte quel que soit le type de pile ou d'accumulateur choisi.

Selon un mode de réalisation particulier, le dispositif est alimenté par la pile ou l'accumulateur.

Ainsi, la présente invention permet de fournir une indication du niveau de charge de la pile afin d'éviter un arrêt du dispositif lié à un défaut d'énergie électrique.

Selon un mode de réalisation particulier, le dispositif est compris dans une vanne thermostatique.

Ainsi, la présente invention permet à une vanne thermostatique nécessitant une quantité d'énergie relativement importante, de fonctionner avec deux types de pile ou d'accumulateur, l'un pour le marché grand public et l'autre pour des professionnels en offrant une autonomie de 2 ans par exemple.

Selon un mode de réalisation particulier, la vanne thermostatique comporte un moteur et le courant au moins supérieur à la seconde valeur prédéterminée est obtenu en alimentant en énergie électrique le moteur.

Ainsi, la présente invention utilise de manière efficiente l'énergie stockée dans la pile ou l'accumulateur en évitant l'arrêt de fonctionnement de l'équipement.

Il est également proposé un programme d'ordinateur qui peut être stocké sur un support et/ou téléchargé d'un réseau de communication, afin d'être lu par un processeur. Ce programme d'ordinateur comprend des instructions pour implémenter le procédé réalisé tel que mentionné ci-dessus, lorsque ledit programme est exécuté par le processeur. L'invention concerne également un support de stockage d'informations stockant un tel programme d'ordinateur.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un exemple d'agencement matériel d'une vanne thermostatique comprenant la présente invention ;
[Fig. 2] illustre schématiquement un exemple d'agencement matériel d'un contrôleur compris dans une tête thermostatique motorisée selon la présente invention ;
[Fig. 3] illustre un exemple de variations de la tension fournie par deux types de piles ou d'accumulateurs différents en fonction de la capacité de la pile ou accumulateur utilisé ; [Fig. 4] illustre schématiquement un exemple d'algorithme exécuté par un contrôleur pour détecter le type de pile ou d'accumulateur utilisé dans le dispositif alimenté par pile ou accumulateur.

### EXPOSE DETAILLE DE MODES DE REALISATION

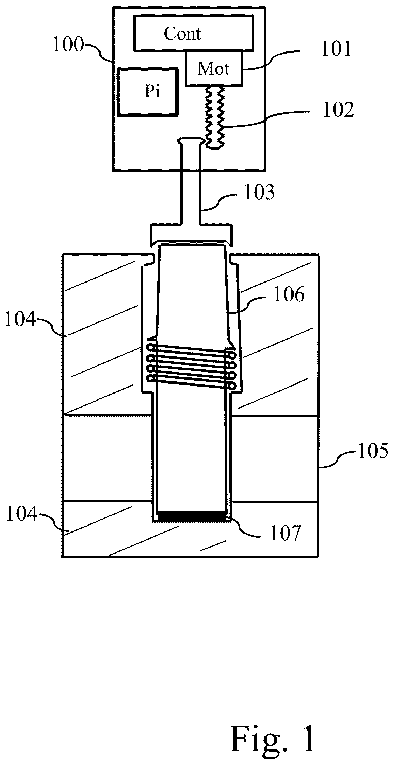

La **Fig.** 1 illustre schématiquement un exemple d'agencement matériel d'une vanne thermostatique comprenant la présente invention.

Le dispositif alimenté par pile ou accumulateur est par exemple compris dans une vanne thermostatique qui permet de contrôler le débit de fluide dans un radiateur.

Une vanne thermostatique est constituée d'un corps de vanne et d'une tête thermostatique. La tête thermostatique permet de régler une température souhaitée dans une pièce d'un bâtiment en déplaçant un élément mobile compris dans le corps de vanne qui module la quantité de fluide circulant dans le radiateur.

Plus précisément, une tête thermostatique motorisée et connectée est représentée en Fig. 1. Les têtes thermostatiques motorisées sont la nouvelle version des têtes thermostatiques et fonctionnent avec une passerelle en connexion à un réseau Internet et parfois avec un thermostat connecté ou une sonde de température.

La tête thermostatique motorisée 100 comporte un contrôleur Cont, un moteur pas à pas 101, une pile ou un accumulateur Pi, des moyens de transmission 102 et un piston 103. Une pile ou un accumulateur peut être constitué d'un ou plusieurs éléments mis en série ou en parallèle.

Le corps de vanne 104 comporte un élément mobile 106 actionné par le piston 103 dont le déplacement module la quantité de fluide circulant dans un conduit 105 relié à un radiateur non présenté dans la Fig. 1.

La tête thermostatique motorisée 100 comporte des moyens de communication radio et/ou un afficheur non représentés en Fig. 1.

Le corps de vanne 104 comporte un joint 107.

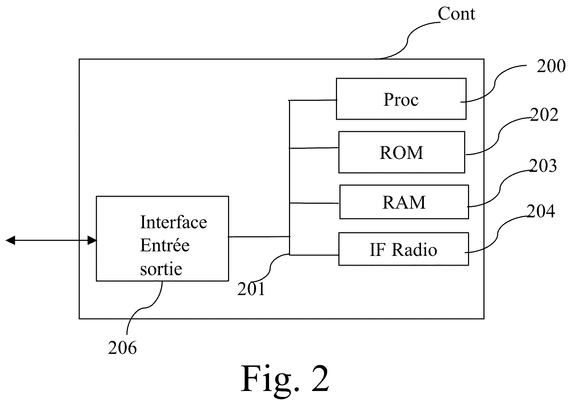

La Fig. 2 illustre schématiquement un exemple d'agencement matériel d'un contrôleur compris dans une tête thermostatique motorisée selon la présente invention.

Le contrôleur Cont comporte, reliés par un bus de communication 201 : un processeur Proc 200 ; une mémoire vive RAM (« Random Access Memory » en anglais) 203 ; une mémoire morte ROM (« Read Only Memory » en anglais) 202 ou une mémoire Flash ; une interface radio 204 et une interface entrée/sortie 206.

L'interface entrée/sortie 206 permet de commander la rotation d'un moteur compris dans la tête thermostatique, d'obtenir une mesure de la tension délivrée par la pile ou l'accumulateur Pi.

Le processeur Proc 200 est capable d'exécuter des instructions chargées dans la mémoire ou d'un réseau de communication. Lors de la mise sous tension du contrôleur Cont, le processeur Proc 200 est capable de lire dans la mémoire RAM 203 des instructions et de les exécuter. Ces instructions forment un programme d'ordinateur causant la mise en œuvre, par le processeur Proc 200, de tout ou partie des comportements, algorithmes et étapes décrits ici.

Ainsi, tout ou partie des algorithmes et étapes décrits ici peut être implémenté sous forme logicielle par exécution d'un ensemble d'instructions par une machine programmable, telle qu'un DSP (« Digital Signal Processor » en anglais) ou un microcontrôleur ou un processeur. Tout ou partie des algorithmes et étapes décrits ici peut aussi être implémenté sous forme matérielle par une machine ou un composant (« chip » en anglais), tel qu'un FPGA (« Field-Programmable Gate Array » en anglais) ou un ASIC (« Application-Specific Integrated Circuit » en anglais). Ainsi, le contrôleur Cont comporte de la circuiterie électronique adaptée et configurée pour implémenter les comportements, algorithmes et étapes décrits ici.

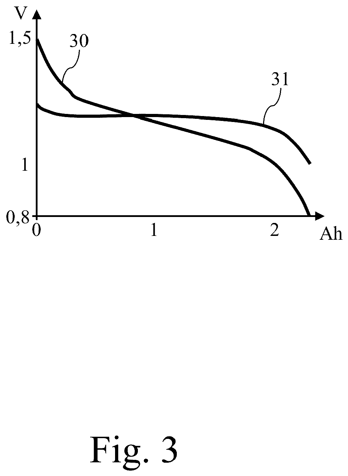

La Fig. 3 illustre un exemple de variations de la tension fournie par deux types de piles ou accumulateurs différents en fonction de la capacité de la pile ou de l'accumulateur utilisé. Dans l'exemple de la Fig. 3, les variations 30 de la tension fournie par une pile de type alcaline et les variations 31 de la tension fournie par un accumulateur de type NIMH en fonction de la capacité de la pile ou de l'accumulateur utilisé sont représentées.

L'axe des abscisses représente la capacité utilisée exprimée en Ampère heure de la pile ou de l'accumulateur.

L'axe des ordonnées représente la tension délivrée par la pile ou l'accumulateur exprimée en Volt.

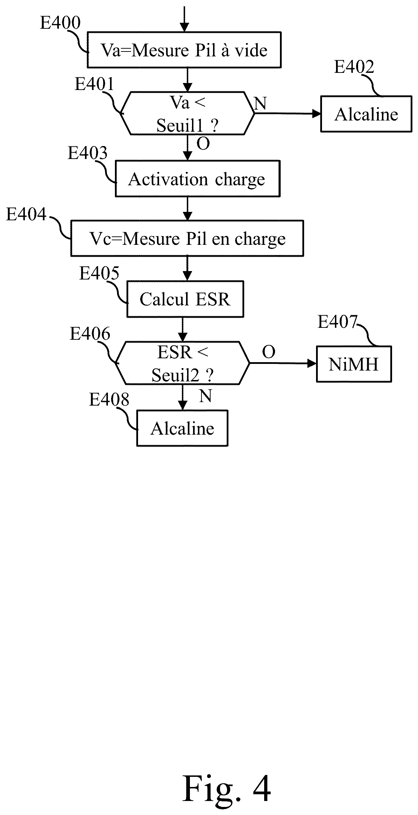

La Fig. 4 illustre schématiquement un exemple d'algorithme exécuté par un contrôleur pour détecter le type de pile ou accumulateur utilisé dans le dispositif alimenté par pile ou accumulateur.

Le présent algorithme est par exemple exécuté à chaque fois que le moteur Mot est activé ou avec une périodicité mensuelle.

A l'étape E400, le contrôleur Cont obtient de l'interface entrée sortie une mesure Va de la tension délivrée par la pile ou l'accumulateur Pil. La tension est obtenue lorsque la pile ou l'accumulateur délivre un courant inférieur à une première valeur prédéterminée, par exemple au maximum un courant de 5 mA. Par exemple, la tension est obtenue lorsque la pile ou l'accumulateur ne délivre que l'énergie nécessaire au fonctionnement du contrôleur Cont.

A l'étape suivante E401, le contrôleur Cont vérifie si la valeur de la mesure Va est inférieure à un premier seuil prédéterminé. Le premier seuil est par exemple égal à 2,8 Volts si deux piles ou accumulateurs en série sont utilisés.

Dans l'affirmative, le contrôleur Cont passe à l'étape 403. Dans la négative, le contrôleur Cont passe à l'étape E402.

Par exemple, les piles alcalines ont une tension nominale de 1,6 V à vide et une tension nominale de 1,5 V. lorsque la pile alcaline est neuve.

Par exemple, les accumulateurs NIMH ont une tension nominale de 1,3 V à vide et une tension nominale de 1,25 V. lorsque l'accumulateur NiMH est chargé.

A l'étape E402, le contrôleur Cont détermine que la pile ou l'accumulateur est du type pile alcaline.

A l'étape E403, le contrôleur Cont commande l'interface entrée sortie 206 pour activer une charge provoquant une consommation en courant Ic au moins supérieure à une seconde valeur prédéterminée, par exemple au moins égale à 100 mA.

Dans l'exemple particulier de la vanne thermostatique, la charge est le moteur Mot.

Le moteur Mot est par exemple un moteur pas à pas bipolaire qui comporte quatre fils, deux pour une phase notée A et deux pour une phase notée B dans un mode dans lequel lorsque la phase A est activée la phase B est en haute impédance et lorsque la phase B est activée la phase A est en haute impédance.

A l'étape E404, le contrôleur Cont commande l'interface entrée sortie 206 pour effectuer une mesure Vc de la tension fournie par la pile ou l'accumulateur.

Dans l'exemple particulier de la vanne thermostatique, la mesure de la tension Vc est effectuée sur la phase activée.

A l'étape suivante E405, le contrôleur Cont détermine la résistance équivalente série ESR de la pile ou de l'accumulateur.

La résistance équivalente série ESR est par exemple calculée selon la formule suivante : ESR= (Va-Vc)/Ic.

A l'étape suivante E406, le contrôleur Cont vérifie si la valeur de la résistance équivalente série calculée est inférieure à un second seuil prédéterminé.

Le second seuil prédéterminé est par exemple égal à 450 mOhms.

Dans l'affirmative, le contrôleur Cont passe à l'étape E407. Dans la négative, le contrôleur Cont passe à l'étape E408.

A l'étape E407, le contrôleur Cont détermine que la pile ou l'accumulateur est du type pile alcaline.

A l'étape E408, le contrôleur Cont détermine que la pile ou l'accumulateur est du type accumulateur NIMH.

A la fin du présent algorithme, le contrôleur Cont connait le type de pile ou d'accumulateur placé dans le dispositif et est apte à utiliser un abaque correspond au type de pile ou d'accumulateur déterminé pour indiquer le niveau de charge restante de la pile ou de l'accumulateur Pil.

## Revendications

1. Procédé de détermination du type de pile ou d'accumulateur utilisé dans un dispositif, **caractérisé en ce que** le procédé comporte les étapes de :
- mesure (E400) de la tension délivrée par la pile ou l'accumulateur lorsque la pile ou l'accumulateur délivre un courant inférieur à une première valeur prédéterminée,
- détermination (E401) que la pile ou l'accumulateur est d'un premier type si la tension délivrée est supérieure à un premier seuil prédéterminé,
- mesure (E404) de la tension délivrée par la pile ou l'accumulateur lorsque la pile ou l'accumulateur délivre un courant au moins supérieur à une seconde valeur prédéterminée,
- calcul (E405) d'une résistance équivalente série de la pile ou de l'accumulateur à partir des deux mesures et du courant au moins supérieur à la seconde valeur prédéterminée,
- détermination (E406) que la pile ou l'accumulateur est d'un second type si la résistance équivalente série est inférieure à un second seuil prédéterminé,
- détermination (E406) que la pile ou l'accumulateur est du premier type si la résistance équivalente série est supérieure au second seuil prédéterminé.

2. Procédé selon la revendication 1, **caractérisé en ce que** le premier type est de type pile alcaline et le second type est de type accumulateur NiMH.

3. Dispositif de détermination du type de pile ou d'accumulateur utilisé dans un dispositif, **caractérisé en ce que** le dispositif comporte :
- des moyens de mesure de la tension délivrée par la pile ou l'accumulateur lorsque la pile ou l'accumulateur délivre un courant inférieur à une première valeur prédéterminée,
- des moyens de détermination que la pile ou l'accumulateur est d'un premier type si la tension délivrée est supérieure à un premier seuil prédéterminé,
- des moyens de mesure de la tension délivrée par la pile ou l'accumulateur lorsque la pile ou l'accumulateur délivre un courant au moins supérieur à une seconde valeur prédéterminée,
- des moyens de calcul d'une résistance équivalente série de la pile ou de l'accumulateur à partir des deux mesures et du courant au moins supérieur à la seconde valeur prédéterminée,
- des moyens de détermination que la pile ou l'accumulateur est d'un second type si la résistance équivalente série est inférieure à un second seuil prédéterminé,
- des moyens de détermination que la pile ou l'accumulateur est du premier type si la résistance équivalente série est supérieure au second seuil prédéterminé.

4. Dispositif selon la revendication 3, **caractérisé en ce que** le premier type est de type pile alcaline et le second type est de type accumulateur NiMH.

5. Dispositif selon la revendication 4, **caractérisé en ce que** le dispositif est alimenté par la pile ou l'accumulateur.

6. Dispositif selon la revendication 6, **caractérisé en ce que** le dispositif est compris dans une vanne thermostatique.

7. Dispositif selon la revendication 6, **caractérisé en ce que** la vanne thermostatique comporte un moteur et **en ce que** le courant au moins supérieur à la seconde valeur prédéterminée est obtenu en alimentant en énergie électrique le moteur.

8. Produit programme d'ordinateur comportant des instructions pour implémenter, par un processeur, le procédé selon la revendication 1 ou 2, lorsque ledit programme est exécuté par ledit processeur.

9. Support de stockage d'informations stockant un programme d'ordinateur comprenant des instructions pour implémenter, par un processeur, le procédé selon la revendication 1 ou 2, lorsque ledit programme est lu et exécuté par ledit processeur.
